(19) Europäisches Patentamt
European Patent Office
Office européen des brevets

(11) Publication number: 0 352 098
A2

# (12) EUROPEAN PATENT APPLICATION

(21) Application number: 89307333.8

(51) Int. Cl.$^5$: G 03 F 7/004

(22) Date of filing: 19.07.89

(30) Priority: 20.07.88 JP 182466/88

(43) Date of publication of application:
24.01.90 Bulletin 90/04

(84) Designated Contracting States: DE GB

(71) Applicant: KONICA CORPORATION
No. 26-2, Nishishinjuku 1-chome Shinjuku-ku
Tokyo (JP)

(72) Inventor: Suzuki, Norihito
Konica Corporation 1 Sakura-machi
Hino-shi Tokyo 191 (JP)

Nakajima, Akihisa
Konica Corporation 1 Sakura-machi
Hino-shi Tokyo 191 (JP)

(74) Representative: Wood, Anthony Charles et al
Urquhart-Dykes & Lord 91 Wimpole Street
London W1M 8AH (GB)

## (54) Waterless presensitized lithographic printing plate.

(57) A waterless presensitized lithographic printing plate is disclosed. The plate comprises a support having thereon a light-sensitive layer and a layer comprising a fluororesin in this order, wherein said fluororesin is a cross-linked fluorine-containing polymer.

EP 0 352 098 A2

**Description**

## WATERLESS PRESENSITIZED LITHOGRAPHIC PRINTING PLATE

### FIELD OF THE INVENTION

The present invention relates to a waterless presensitized lithographic printing plate, specifically a waterless presensitized lithographic printing plate whose printing face is not susceptible to scratches and whose printability is good.

### BACKGROUND OF THE INVENTION

A known conventional waterless presensitized lithographic printing plate (hereinafter referred to as waterless PS plate as necessary) comprises a support and a light sensitive layer and ink repellent layer both formed thereon in due order. A waterless lithographic printing plate (hereinafter referred to as waterless printing plate as necessary) can be obtained by exposuring and developing this waterless PS plate.

A fluororesin is used in ink repellent layer in some known methods. For example, Japanese Patent O.P.I. Publication No. 215411/1983 discloses a waterless printing plate having an ink repellent layer comprising a copolymer containing a particular fluorine-containing acrylic monomer and another monomer having light sensitive group.

However, this waterless printing plate is faulty in that its printability is not sufficient and its shadow part and dot reproducibility is poor.

In addition, this waterless printing plate can be developed with a developer containing methaxylene hexafluoride or another fluorine compound, but cannot be developed with a developer other than a fluorine-based developer. This fact leads to a lack of good selectivity for developer; the strong reactivity of fluorine hampers easy handling of developer; a waste treatment problem arises.

Furthermore, this waterless printing plate has another drawback; increasing the light sensitive group content to improve the printability or reproducibility causes a decrease in ink repellency and thus an increase in the possibility of field staining.

Meantime, the specification for W083-02175 discloses a waterless PS plate having an ink repellent layer comprising a perfluoroalkyl compound having a metal atom and a functional group bound to the metal atom. This method is unique in that high resolution can be obtained since the existence of the metal atom improves the layer adherence and thus permits the reduction of ink repellent layer thickness to 10 Å. However, this method is faulty in that the obtained printability is not sufficient and streaky stains occur over the entire surface of the printing plate.

### SUMMARY OF THE INVENTION

Accordingly, the object of the present invention is to provide a waterless presensitized lithographic printing plate which has excellent printability and excellent shadow part and dot reproducibility, which permits the use of a developer other than a fluorine-based developer, and which is free of the possibility of field staining on printing face.

### DETAILED DESCRIPTION OF THE INVENTION

With the aim of accomplishing this object, the present inventors made investigations and developed the present invention.

Accordingly, the waterless presensitized lithographic printing plate of the present invention comprises a support and a light sensitive layer and a layer comprising a fluororesin formed thereon in this order, said fluororesin being formed with a fluorine-containing polymer mutually crosslinked directly or via a crosslinking agent.

The present invention has the structure in which a light sensitive layer and a fluororesin layer are formed on a support in this order, and a mutually crosslinked fluorine-containing polymer is used in the fluororesin; therefore, the present invention excels conventional waterless PS plates using an ordinary fluororesin in printability and shadow and dot reproducibility, and in addition, it permits the use of an ordinary developer other than a fluorine-based developer and is free of the possibility of field staining on printing face and other drawbacks found in conventional waterless PS plates.

The support of the present invention is preferably a material which is sufficiently flexible so that it can be applied to ordinary lithography machines and which withstands the load exerted during the printing process. The examples of the support include metal plates such as of aluminum, zinc, copper and steel; metal plates,

paper, plastic films and glass plates plated or vapor deposited with chromium, zinc, copper, nickel, aluminum, iron or other metal; resin coated paper; and paper coated with aluminum or other metal. Among these materials, aluminum plates are preferred.

There is no particular limitation on the choice of treatment of the support itself to improve the adhesion; various surface roughing treatments can be conducted.

The support may have a primer layer. The examples of the resin contained in the primer layer include polyester resin, vinyl chloride-vinyl acetate copolymer, acrylic resin, vinyl chloride resin, polyamide resin, polyvinyl butyral resin, epoxy resin, acrylate copolymer, vinyl acetate copolymer, phenoxy resin, polyurethane resin, polycarbonate resin, polyacrylonitrile butadiene and polyvinyl acetate. Epoxy resin is especially preferable.

The examples of the anchor agent composing the primer layer include silane coupling agents and silicone primers used in the silicone rubber layer; organic titanates and other anchor agents are also effective.

The silane coupling agent is a silane compound represented by the formula:

$(R)_nSiX_{4-n}$

wherein n represents an integer of 1 to 3; $R^1$ represents an alkyl group, aryl group, alkenyl group or monovalent group comprising a combination thereof, which may have a functional group such as a halogen atom, an amino group, a hydroxy group, an alkoxy group, an aryloxy group or a thiol group; X represents a substituent such as -OH, $-OR^2$, $-OCOCH_3$,

$-OCOCH_3$, 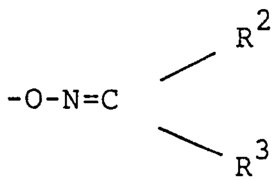 , -Cℓ, -Br or -I; $R^2$ and $R^3$

-Cℓ, -Br or -I; $R^2$ and $R^3$ have the same definitions as R above, whether they are identical or not. The examples of the silane compound include $HN[(CH_2)_3Si(OCH_3)_3]_2$, vinyltrichlorosilane, vinyltriethoxysilane, $Cℓ(CH_2)_3Si(OCH_3)_3$, $CH_3Si(-OCOCH_3)_3$, $HS(CH_2)_3Si(OCH_3)$ and vinyltris(methylethylketoxime) silane.

There is no particular limitation of the choice of the light sensitive material for the light sensitive layer of the present invention. As examples of the light sensitive material, mention may be made of quinone diazide type positive type light sensitive materials such as well-known o-naphthoquinonediazide compounds. The examples of the preferable o-naphthoquinonediazide compound include the ester of naphthoquinone-(1,2)-diazide-(5)-sulfonic acid chloride and phenol or cresol-formaldehyde resin, disclosed in U.S. Patent No. 3,046,120. The examples of other useful o-naphthoquinonediazide compounds include the ester of pyrogallol-acetone resin and o-naphthoquinonediazide sulfonic acid chloride, disclosed in U.S. Patent No. 3,635,709, the ester of polyhydroxyphenyl resin and o-naphthoquinonediazidesulfonic acid chloride, disclosed in Japanese Patent O.P.I. Publication Nos. 76346/1980, 1044/1981 and 1045/1981, the product obtained by esterifying a p-hydroxystyrene homopolymer or copolymer of p-hydroxystyrene and copolymerizable monomer with o-naphthoquinonediazidesulfonic acid chloride, disclosed in Japanese Patent O.P.I. Publication No. 113305/1975, the reaction product of a styrene monomer-phenol derivative polymer and o-quinonediazidesulfonic acid, disclosed in Japanese Patent Examined Publication No. 17481/1974, and the ester of polyhydroxybenzophenone and o-naphthoquinonediazidesulfonic acid chloride.

The light sensitive composition containing such a quinonediazide type positive type light sensitive material may contain a binder added as needed. The examples of preferable binders include novolac resins soluble in aqueous alkali solutions. Representative examples of such novolac resins include phenol-formaldehyde resin, cresol-formaldehyde resin, p-tert-butylphenol-formaldehyde resin and phenol-modified xylene resin.

The quinonediazide compound content of the light sensitive layer is 10 to 50% by weight, preferably 20 to 40% by weight. The ratio of the binder is 45 to 80% by weight, preferably 50 to 70% by weight, relative to the light sensitive layer composition.

The following light sensitive materials can be used for the present invention. For example, it is possible to use diazo resins exemplified by condensation products of aromatic diazonium salts and formaldehyde. The examples of especially preferable diazo resins include diazo resin inorganic salts obtained by reaction of the above condensation product and a salt, such as hexafluorophosphate, tetrafluoroborate, perchlorate or periodate, of the condensation product of p-diazodiphenylamine and formaldehyde or acetaldehyde; diazo resin organic salts obtained by reaction of the above condensation product and sulfonic acid as disclosed in U.S. Patent No. 3,300,309. The diazo resin is preferably used in combination with a binder. Various high polymer compounds can be used as binders for this purpose. The examples of preferable binders include copolymers of a monomer having an aromatic hydroxy group, such as N-(4-hydroxyphenyl)acrylamide,= N-(4-hydroxyphenyl)methacrylamide, o-, m- or p-hydroxystyrene, o-, m- or p-hydroxyphenyl methacrylate and other monomer, as disclosed in Japanese Patent O.P.I. Publication No. 98613/1979, polymers consisting mainly of repeat units of hydroxyethyl acrylate or hydroxyethyl methacrylate, as disclosed in U.S. Patent No. 4,123,276, natural resins such as shellac and rosin, polyvinyl alcohol, the polyamide resin disclosed in U.S. Patent No. 3,751,257, the linear polyurethane resin disclosed in U.S. Patent No. 3,660,097, polyvinyl alcohol

phthalate resin, epoxy resins obtained by condensation of bisphenol A and epichlorohydrin, and celluloses such as cellulose acetate and cellulose acetate phthalate.

Mention may also be made of light sensitive materials consisting mainly of a light sensitive polymer having

$-CH=CH-\underset{\underset{O}{\|}}{C}-$

as the light sensitive group in its polymer main chain or side chain, such as polyesters, polyamides and polycarbonates. The examples of such light sensitive materials include light sensitive polyesters obtained by condensation of phenylenediethyl acrylate, hydrogenated bisphenol A and triethylene glycol, as disclosed in Japanese Patent O.P.I. Publication No. 40415/1980, and light sensitive polyesters derived from a (2-propelidene)malonic acid compound such as cinnamylidenemalonic acid and a bifunctional glycol, as disclosed in U.S. Patent No. 2,956,878.

Mention may also be made of aromatic azide compounds in which the azide group is bound to the aromatic ring directly or via a carbonyl or sulfonyl group. The examples of the aromatic azide compound include polyazidestyrene, polyvinyl-p-azidobenzoate, and polyvinyl-p-azidobenzal, as disclosed in U.S. Patent No. 3,096,311; the reaction product of azidoarylsulfanyl chloride and unsaturated hydrocarbon polymer disclosed in Japanese Patent Examined Publication No. 9613/1970; and polymers having sulfonylazide or carbonylazide as disclosed in Japanese Patent Examined Publication Nos. 21067/1968, 229/1969, 22954/1969 and 24915/1970.

Mention may also be made of photopolymerizable compositions comprising a addition-polymerizable unsaturated compound. The examples of the unsaturated monomer that can be used for this purpose include acrylates or methacrylates of alcohols (e.g. ethanol, propanol, hexanol, octanol, cyclohexanol, ethylene glycol, propylene glycol, diethylene glycol, triethylene glycol, tetraethylene glycol, polyethylene glycol, glycerol trimethylolpropane, pentaerythritol); reaction products of glycidyl acrylate or glycidyl methacrylate with amines (e.g. methylamine, ethylamine, butylamine, benzylamine, ethylenediamine, diethylenetriamine, hexamethylenediamine, xylilenediamine, dimethylamine, diethylamine, ethanolamine, diethanolamine, aniline); reaction products of glycidyl acrylate or glycidyl methacrylate with carboxylic acids (e.g. acetic acid, propionic acid, benzoic acid, acrylic acid, methacrylic acid, succinic acid, maleic acid, phthalic acid, tartaric acid, citric acid); amide derivatives (e.g. acrylamide, methacrylamide, N-methylolacrylamide, methylenebisacrylamide); and reaction products of acrylic acid or methacrylic acid with epoxy compounds.

The examples of substances which can be used as a photo-initiator include benzoin derivatives such as benzoin methyl ether, benzoin isopropyl ether and α,α-dimethoxy-α-phenylacetophenone; benzophenone and its derivatives such as 2,4-dichlorobenzophenone, methyl o-methyl o-benzoylbenzoate, 4,4′-bis(diethylamino)benzophenone and 4,4′-bis(diethylamino)benzophenone; thoxanthone derivatives such as 2-chlorothioxanthone and 2-isopropylthioxanthone; anthraquinone derivatives such as 2-chloroanthraquinone and 2-methylanthraquinone; acridone derivatives such as N-methylacridone and N-butylacridone; α,α-diethoxyacetophenone; benzyl; fluorenone; xanthone; uranyl compounds; and halogen compounds.

It is preferable to add a binder to this photopolymerizable composition. The above-mentioned substances used as the binder in quinonediazide type positive sensitive materials or diazo resins can be used as the binder in the case as well. It is preferable to use a photocrosslinkable copolymer having an ethylenically unsaturated bond in its side chain described in Japanese Patent Examined Publication No. 17874/1974 etc.

In addition to the above-mentioned additives, the light sensitive layer may contain a dye for post-exposure or post-development image visualization [e.g. triphenylmethane-or diphenylmethane-based dyes such as Victoria Pure Blue BOH (produced by Hodogaya Chemical) and Oil Blue #603 (produced by Orient Chemical)], alkyl ethers for coatability improvement (e.g. ethylcellulose, methylcellulose), fluorine-based surfactants, nonionic surfactants [e.g. Pluronic L64 (produced by Asahi Denka)], plasticizer for providing coating film flexibility (e.g. polyethylene glycol, tricresyl phosphate, acrylic or methacrylic polymer), and stabilizer (e.g. phosphoric acid, oxalic acid, tartaric acid).

The fluororesin layer of the present invention is an ink repellent layer. The crosslinked fluorine-containing polymer for this layer is derived from a fuluorine-containing polymer and has in its molecular structure (1) one of the following structural units:

$CF_3-$ , $-CF_2-$ , $-\underset{|}{C}F-$

$CF_3-0-$, $-CF_2-0-$ , $-\underset{|}{C}F-0-$

(the fluorine content is over 30% by weight, preferably over 50% by weight), and (2) one of the following functional groups:

$-OH$, $-COOH$, $-NH_2$,

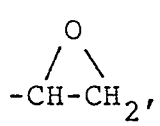

$-NCO$, $-NH-$, $-\overset{\overset{O}{\|}}{C}-O-\overset{\overset{O}{\|}}{C}-$ etc.

The example polymers are given below.

1) Copolymer resins of perfluoroalkyl methacrylate and a hydroxy group-containing acryl monomer such as 2-hydroxyethyl methacrylate.

2) Copolymer resins of perfluoroalkyl methacrylate and glycidyl methacrylate.

3) Copolymer resins of a fluorine-containing acrylate represented by the formula:

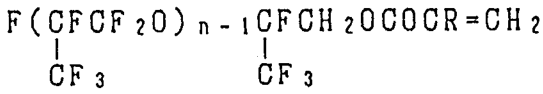

and 2-methacryloxyloxyethyl isocyanate 0

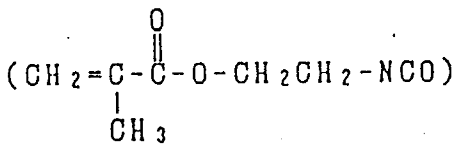

4) Copolymer resins of perfluoroalkyl mehtacrylate and methacrylic acid.

5) Copolymer resins of perfluoroalkyl mehtacrylate and maleic anhydride.

The fluorine-containing polymer described above of the present invention is preferably a copolymer resin of a fluorine-containing acryl monomer and another monomer having the above mentioned functional group in the molecular structure.

The preferable fluorine-containing acryl monomers are represented by the following formula:

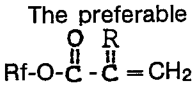

wherein Rf represents an fluorine-containing alkyl group or a fluorine-containing polyether group; R represents a hydrogen atom or an alkyl group.

The examples of the preferable fluorine-containing acryl monomers include the following monomers:

(1) 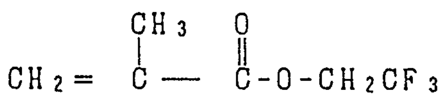

(2) 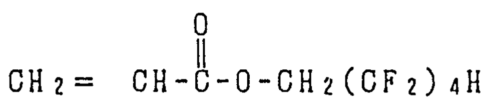

(3) 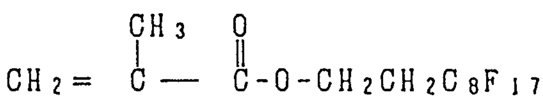

(4) 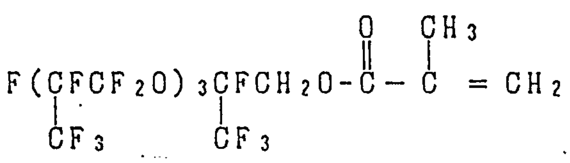

The examples of the monomer capable of copolymerizing with the fluorine-containing acryl monomer include glycidyl methacrylate, methacrylic acid and 2-hydroxy methacrylate.

It is also preferable that the fluorine-containing polymer for the present invention be a copolymer of the above-mentioned fluorine-containing acryl monomer, another monomer having a functional group capable of copolymerizing with this acryl monomer and a third monomer for improvement of film forming property. The examples of the third monomer include styrene, methyl methacrylate (MMA), butyl acrylate, acrilonitrile and ethyl acrylate.

The crosslinked fluoro-containing polymer is, preferably crosslinked by a crosslinking agent.

When the fluorine-containing polymer of the present invention has an active hydrogen functional group such as -OH, -COOH, $-NH_2$ or -NH-, it is preferable to use a compound having in its molecular structure at least two functional groups capable of reacting with active hydrogen such as

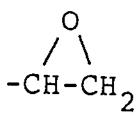

and -NCO as the crosslinking agent. The example compounds are given below.

(1) Hexamethylene diisocyanate

(2)

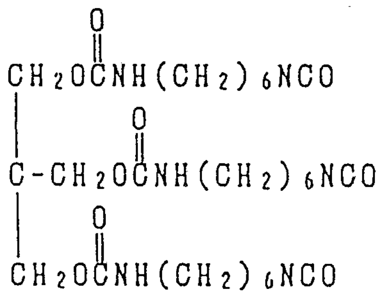

(3) Pentaerythritol polyglycidyl ether

(4) Bisphenol A diglycidyl ether

When the fluorine-containing polymer of the present invention has a functional group capable of reacting with active hydrogen such as

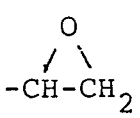

or -NCO, it is possible to use a compound having an active hydrogen functional group such as -OH, -COOH, $-NH_2$ or -NH- as the crosslinking agent.

The examples of such compounds include pentaerythritol, polyvinyl alcohol, 2-hydroxyethyl methacrylate copolymer resin, pentaerythritol diacrylate, diethylenetriamine and acrylic copolymer resin.

It is preferable that the crosslinked fluorine-containing polymer in the fluorine-containing polymer layer of the present invention be bound with a compound in the light sensitive layer or a crosslinking agent.

When the fluororesin of the present invention has a functional group capable of reacting with active hydrogen such as

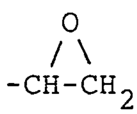, 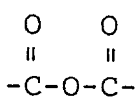

or -NCO, a compound having at least two active hydrogen functional groups such as -OH, -COOH, $-NH_2$ and -NH- is used as the crosslinking agent, and a compound having a functional group capable of reacting with active hydrogen such as

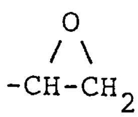, 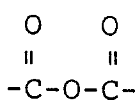

or -NCO, can be used as the light sensitive layer compound.

When the fluororesin of the present invention has active hydrogen functional group such as -OH, -COOH, $-NH_2$ and -NH-, a compound having at least two functional groups capable of reacting with active hydrogen such as

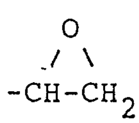, 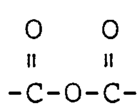

or -NCO is used as the crosslinking agent, and a compound having a functional group such as -OH, -COOH, $-NH_2$ and -NH- can be used as the light sensitive layer compound.

The fluorine-containing polymer content of the fluorine-containing polymer layer of the present invention is normally 60 to 100% by weight, preferably 80 to 98% by weight, as which a very high effect is obtained.

The fluororesin can be added by any method, including the method in which the fluororesin is added directly to an organic solvent and the method in which a solution of the fluororesin in an appropriate solvent is added to an organic solvent. The examples of the organic solvent for this purpose include organic solvent used for the developer described below.

The fluororesin layer of the present invention is formed by coating a solution of the fluorine-containing polymer and crosslinking agent in an appropriate solvent on the light sensitive layer and drying and heating the coated, whereby the fluorine-containing polymer is crosslinked or the fluorine-containing polymer and the light sensitive layer compound are crosslinked together directly or via the crosslinking agent.

In addtion to the above-mentioned components, a catalyst for crosslinking reaction can be contained in a small amount, for example, a tin compound such as dibutyltin laurate, or a quaternary or tertiary amine compound such as triethylbenzylammonium chloride or benzyldimethylamine.

The thickness of each layer comprising the waterless PS plate of the present invention is 50 to 400 μm, preferably 100 to 300 μm for the support, 0.05 to 10 μm, preferably 0.5 to 5 μm for the light sensitive layer, and 0.01 to 10 μm, preferably 0.1 to 1 μm for the fluororesin layer.

In the present invention, the fluororesin layer may have a protective layer formed on the upper surface thereof as needed.

The waterless PS plate of the present invention is, for example, produced as follows:

A solution of the composition to constitute the light sensitive layer is coated on the support by means of an ordinary coater such as a reverse roll coater, air knife coater or Meyer bar coater, or a rotary coater such as a whirler, and this is followed by drying and, if needed, thermal curing.

A primer layer may be formed as necessary between the support and the light sensitive layer in the same manner as with the light sensitive layer. The light sensitive layer thus obtained is then coated with a fluorine-containing polymer and crosslinking agent in the same manner as above, and this is followed by thermal treatment as 100 to 120°C for several minutes for surfficient hardening to yield a fluororesin layer. A protective film may be formed on the fluororesin layer by means of a laminator or other means as necessary.

The method of producing a waterless printing plate from the waterless PS plate of the present invention is described below.

A positive film as the original is placed in close contact with the surface of the positive waterless PS plate under vacuum conditions and exposed. The examples of the light source for this exposure include mercury vapor lamps, carbon arc lamps, xenon lamps, metal halide lamps, fluorescent lamps and other lamps that generate high intensities of ultraviolet ray.

The positive film is then stripped off and developed with a developer. Known developers for waterless PS plates can be used for this development. The examples of preferable developers include developers prepared by adding a polar solvent to an aliphatic hydrocarbon [e.g. hexane, heptane, "Isopar E, H, and G" (tradenames for aliphatic hydrocarbons produced by Esso Chemical), gasoline, kerosene], aromatic hydrocarbon (e.g. toluene, xylene) or hydrocarbon halide (e.g. trichlene).

The examples of the polar solvent include alcohols (e.g. methanol, ethanol, water), ethers (e.g. methylcellosolve, ethylcellosolve, butylcellosolve, methylcarbitol, ethylcarbitol, butylcarbitol, dioxane), ketones (e.g. acetone, methyl ethyl ketone), esters (e.g. ethyl acetate, methylcellosolve acetate, cellosolve acetate, carbitol acetate).

It is also possible to dye the image portion simultaneously with development by adding a dye such as Crystal Violet or Astrazone Red to the developer.

Development can be achieved by a known method such as the method in which the printing plate surface is rubbed with a developing pad moistened with a developer as described above or the method in which the printing plate surface is rubbed with a developing brush after pouring the developer over the printing plate surface.

The above development gives a printing plate whose fluroine-containing polymer in the unexposed portion has been removed so that the light sensitive layer has become naked and whose fluororesin layer remains intact in the exposed portion.

A printing plate can also be obtained by exposuring the original negative film placed in contact with a negative waterless printing plate.

## EXAMPLES

The present invention is hereinafter described in more detail by means of the following examples.

Note that the term "part" used below means "part by weight" unless otherwise stated.

### Example 1

A degreased aluminum plate of 0.24 mm in thickness was coated with the following primer layer composition and dried at 150°C for 3 minutes to yield a primer layer of 2 μm in thickness.

Primer layer composition

| | |
|---|---|
| Epikote 1001 (bisphenol A epoxy resin produced by Yuka-Shell Epoxy Co.) | 50 parts |
| Epomate S002 (curing agent produced by Yuka-Shell Epoxy Co.) | 50 parts |
| Toluene | 400 parts |
| Methylcellosolve | 400 parts |

The primer layer thus obtained was coated with the following light sensitive composition and dried at 100°C for 2 minutes to yield a light sensitive layer of 2 µm in thickness.

Light sensitive composition

| | | |
|---|---|---|
| (1) | Resin obtained by adding glycidyl methacrylate to the carboxyl group of a copolymer resin of styrene, acrilonitrile, butyl acrylate and acrylic acid in a molar ratio of 41:28:3:28 (synthesized by the method described in Japanese patent Examined Publication No. 17874/1974) | 100 parts |
| (2-1) | Tetramethylolmethane tetramethacrylate | 20 parts |
| (2-2) | Trimethylolpropane triacrylate | 40 parts |
| (3) | 2,4-diethylthioxanthone | 3 parts |
| (4) | Isoamyl p-dimethylaminobenzoate | 3 parts |
| (5) | Victoria Pure Blue BOH (dye produced by Hodogaya Chemical) | 1.0 part |
| (6) | Methylcellosolve | 500 parts |

The fluorine-containing polymer composition 1 was then coated on the light sensitive layer and heated at 120°C for 3 minites to crosslink the fluorine-containing polymer, whereby a hardened fluorine-containing polymer layer of 1.0 µm in thickness was obtained.

Fluorine-containing polymer composition 1

(A) Copolymer resin of 1H,1H,2H,2H-heptadecafluorodecyl methacrylate

| | | |
|---|---|---|
| | $[CH_2=C(CH_3)COO(CH_2)_2(CF_2)_8F]$, 2-hydroxyethyl methacrylate and methyl methacrylate in a molar ratio of 70:20:10 | 40 parts |
| (B) | Coronate EH (polyisocyanate produced by Nippon Polyurethane) | 2 parts |
| (C) | Dibutyltin dilaurate | 0.05 part |
| (D) | Flon-113 | 200 parts |
| (E) | m-xylene hexafluoride | 20 parts |

The fluorine-containing polymer layer thus obtained was laminated with a single-side-matted PET film of 12 µm in thickness to yield a waterless PS plate.

A positive film was placed in close contact with the upper surface of this waterless PS plate under vacuum conditions and exposed using a metal halide lamp. The laminated film was then stripped off and the plate surface was rubbed with a developing pad moistened with the following developer to remove the fluorine-containing polymer layer in the unexposed portion, whereby a waterless lithographic printing plate was obtained.

Developer composition

| | |
|---|---|
| Isopar H | 70 parts |
| Toluene | 10 parts |
| Sorbitol (produced by Kuraray Isoprene Chemical) | 20 parts |

The waterless printing plate thus obtained was then applied to a Heidelberg GTO press from which the water supplier had been detached and subjected to a printing process using OPI WLP PROCESS W PED N, produced by Osaka Ink. A total of 20,000 sheets of printed matter having good dot reproducibility and good shadow reproducibility were obtained.

Example 2

The procedure of Example 1 was followed, but the following fluorine-containing polymer composition 2 was used in place of the fluorine-containing polymer composition 1 of Example 1, to yield a waterless printing plate, which was then subjected to the same printing process as in Example 1. A total of 20,000 sheets of printed matter having good dot reproducibility and good shadow reproducibility were obtained.

Fluorine-containing polymer composition 2

(1) Copolymer resin of

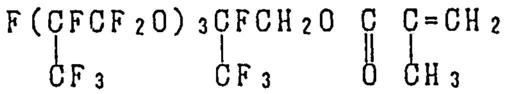 [23FO]

methyl methacrylate and methacrylic acid in a molar ratio of 60:10:20 — 40 parts

(2) Copolymer resin of 23FO, methyl methacrylate and glycidyl methacrylate in a molar ratio of 60:10:20 — 40 parts

(3) Copolymer resin of 23FO, methyl methacrylate and dimethylaminoethyl methacrylate in a molar ratio of 60:10:20 — 20 parts

(4) Flon-113 — 200 parts

(5) m-xylene hexafluoride — 50 parts

Comparison Example 1

A waterless printing plate was prepared in accordance with the method of Example 2 of the specification for W083-02175. A solution which basic chromium (III) chloride and an ink-repellent perfluoro compound represented by formula below were dessolved in isopropanol was prepared.

$CF_3(CF_2)_{19}$-COOH

A negative typed presensitized offset plate (SGN-II , make of Fuji Shasin Film Co.) was coated with the above solution and cured at 60°C for 15 minutes. A positive film was put on the plate obtained above and contacted close by vacuum and was exposed for 2 minutes at a distance of 10 cm from a chemical lamp. The exposed plate was developed a solution of a developer for a presensitized plate, DN-C and methanol (1:1) rubbing softly with a absorbent cotton, washed with water and dried. The plate was subjected to the same printing process as in Example 1. Streaky stains were noted on the entire printing face when 1,000 sheets were printed.

Comparison Example 2

A waterless printing plate was prepared in accordance with the method of Example 1 of the specification for Japanese Patent O.P.I Publication No. 215411/1983.

A sensitive solution of a composition shown below was prepared.

A composition

| | |
|---|---|
| m-xylenehexafluoride (a solvent) | 100 mℓ |
| a copolymer of 2-cinnamoyloxyethylmethacrylate | |
| and 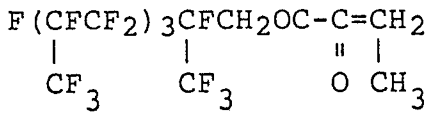 | |
| (a sensitive compound) | 5 g |
| 5-nitroacenaphthene | 0.1 g |

The solution was coated on a smooth surface of an aluminum plate at 200 rpm of a round rate by a whirler and dried to be 2 µm thick. The thus obtained plate was contacted close with a transparent original having a half tone positive image of 200 line/inch and exposed with a 20 W chemical lamp for 5 minutes at a distance of 10 cm from the lamp, followed by developing with m-xylenehexafluoride. The plate was subjected to the same printing process as in Example 1. Light field stains were noted on the entire printing face when 2,000 sheets were printed.

In addition, this plate could not be developed with the developer of Example 1, though it was developable with methaxylene hexafluoride.

The shadow reproducibility and dot reproducibility were both poor.

Example 3

A degreased aluminum plate of 0.24 mm in thickness was coated with the following primer layer composition and cured at 150°C for 3 minutes to yield a primer layer of 2 µm in thickness.

Primer layer composition 3

| | |
|---|---|
| Epikote 1001 (bisphenol A epoxy resin produced by Yuka-Shell Epoxy Co. | 50 parts |
| Epomate S002 (curing agent produced by Yuka-Shell Expoxy Co.) | 50 parts |
| Toluene | 400 parts |
| Methylcellosolve | 400 parts |

The primer layer thus obtained was coated with the following light sensitive composition and dried at 100°C for 2 minutes to yield a light sensitive layer of 2 µm in thickness.

Light sensitive composition 3

(1) Resin obtained by adding glycidyl methacrylate to the carboxyl group of a copolymer resin of styrene, acrilonitrile, butyl acrylate and acrylic acid in a molar ratio of 41:28:3:28 (synthesized by the method

| | | |
|---|---|---|
| | described in Japanese patent Examined Publication No. 17874/1974) | 100 parts |
| (2-1) | 4:1 adduct of glycidyl methacrylate and methaxylenediamine | 100 parts |
| (2-2) | Trimethylolpropane triacrylate | 40 parts |
| (3) | 2,4-diethylthioxanthone | 3 parts |
| (4) | Isoamyl p-dimethylaminobenzoate | 3 parts |
| (5) | Victoria Pure Blue BOH (dye produced by Hodogaya Chemical) | 1.0 part |
| (6) | Methylcellosolve | 500 parts |

The fluorine-containing polymer composition 3 was then coated on the light sensitive layer and heated at 90°C for 10 minites to crosslink the fluorine-containing polymer, whereby a hardened fluorine-containing polymer layer of 1.0 µm in thickness was obtained.

Fluorine-containing polymer composition 3

| | | |
|---|---|---|
| (1) | Copolymer resin of 1H,1H,2H,2H-heptadecafluorodecyl methacrylate [$CH_2=C(CH_3)COO(CH_2)_2(CF_2)_8F$], 2-hydroxyethyl methacrylate and methyl methacrylate in a molar ratio of 80:10:10 | 40 parts |
| (2) | Coronate EH (polyisocyanate produced by Nippon Polyurethane) | 1 part |
| (3) | Dibutyltin dilaurate | 0.05 part |
| (4) | Flon-113 | 200 parts |
| (5) | 2-butanone | 20 parts |

The fluorine-containing polymer layer thus obtained was laminated with a single-side-matted polyethylene terephthalate film of 12 µm in thickness to yield a waterless presensitized lithographic printing plate.

A positive film was placed in close contact with the upper surface of this waterless PS plate under vacuum conditions and exposed using a metal halide lamp as the light source.

The laminated film was then stripped off from the surface of the exposed waterless PS palte, and this was followed by developing with the following developer. During the developing process, the plate surface was rubbed with a developing pad to easily remove the fluororesin layer in the unexposed portion alone, whereby a waterless lithographic printing plate was obtained.

Developer composition 3

| | |
|---|---|
| Isopar II | 70 parts |
| Toluene | 3 parts |
| Sorbitol (produced by Kuraray Isoprene Chemical) | 27 parts |

The printing plate thus obtained was then applied to a Heidelberg GTO press from which the water supplier had been detached and subjected to a printing process using OPI WLP PROCESS W RED H, produced by Osaka Ink. A total of 20,000 sheets of printed matter having good dot reproductibility and good shadow reproducibility were obtained.

Example 4

The procedure of Example 3 was followed, but the following fluorine-containing polymer composition 4 was used in place of the fluorine-containing polymer composition 3 of Example 3, to yield a waterless PS plate, which was developed to yield a printing plate. This printing plate was found to have a strongly adhered fluororesin layer in the exposed portion, and was subjected to the same printing process as in Example 3. A total of 20,000 sheets of printed matyter having good dot reproducibility and good shadow reproducibility were obtained.

Fluorine-containing polymer composition 4

(1) Copolymer resin of

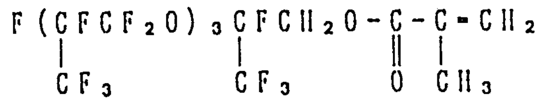

[23FO]

methyl methacrylate and 2-hydroxyethyl methacrylate in a molar ratio of 70:20:10 — 40 parts

(2) Coronate EH (polyisocyanate produced by Nippon Polyurethane) — 1 part

(3) Dibutyltin dilaurate — 0.05 part

(4) Flon-113 — 200 parts

(5) m-xylene hexafluorinde — 50 parts

Example 5

The procedure of Example 3 was followed, but the following light sensitive composition 5 was used in place of the light sensitive composition 3 of Example 3, to yield a waterless PS plate, which was developed to yield a printing plate.

This printing plate was found to have a strongly adhered fluororesin layer in the exposed portion, and was subjected to the same printed matter having good dot reproducibility and good shadow reproducibility were obtained.

Light sensitive composition 5

| | | |
|---|---|---|
| (1) | Copolymer resin of allyl methacrylate and methacrylic acid in a molar ratio of 85:15 (synthesized by the method described in Japanese patent Examined Publication No. 46643/1984) | 50 parts |
| (2-1) | Tetramethylolmethane tetramethacrylate | 20 parts |
| (2-2) | Trimethylolpropane triacrylate | 40 parts |
| (3) | 2-trichloromethyl-5-(p-n-butoxystyryl)-1,3,4-oxadiazole | 5 parts |
| (4) | Styrene-maleic anhydride copolymer resin | 50 parts |
| (5) | Victoria Pure Blue BOH (dye produced by Hodogaya Chemical) | 1.0 part |
| (6) | Methylcellosolve | 500 parts |

Example 6

The procedure of Example 3 was followed, but the following light sensitive composition 6 was used in place of the light sensitive composition 3 of Example 3 and the following fluorine-containing polymer composition 6 was used in place of the fluorine-containing polymer composition 3, to yield a sample.

Light sensitive composition 6

| | | |
|---|---|---|
| (1) | Styrene-maleic anhydride copolymer (Stylite CM-2L, produced by Sankyo Kasei) | 30 parts |
| (2) | Carboxylic half ester polymer obtained by reaction of 80 parts of styrene-maleic anhydride copolymer (Stylite CM-2L, produced by Sankyo Kasei) and 20 parts of pentaerythritol triacrylate (synthesized by the method described in Japanese Patent O.P.I. Publication No. 71048/1984) | 70 parts |
| (3) | Trimethylolpropane triacrylate | 50 parts |
| (4) | 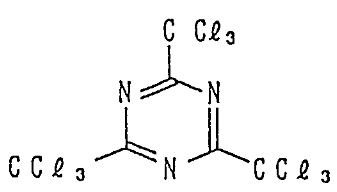 | 5 parts |

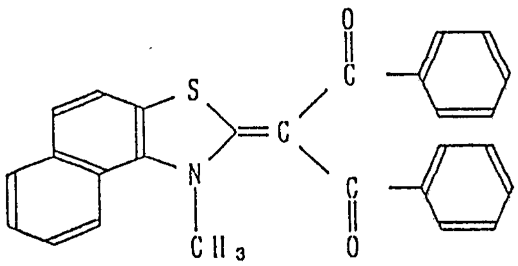

5 parts

(6) Victoria Pure Blue BOH (dye produced by Hodogaya Chemical) 1.0 part

(7) Ethylcellosolve 500 parts

Fluorine-containing polymer composition 6

| | | |
|---|---|---|
| (1) | Copolymer resin of 1H,1H,2H,2H-heptadecafluorodecyl methacrylate [$CH_2=C(CH_3)COO(CH_2)_2(CF_2)_8F$], 2-hydroxyethyl methacrylate and methyl methacrylate in a molar ratio of 80:15:5 | 100 parts |
| (2) | Coronate EH (polyisocyanate produced by Nippon Polyurethane) | 1 part |
| (3) | Dibutyltin dilaurate | 0.05 part |
| (4) | Flon-113 | 200 parts |
| (5) | 2-butanone | 100 parts |

A light sensitive layer comprising the light sensitive composition 6 was then formed on the support in the same manner as in Example 3. The fluorine-containing polymer composition 6 was then coated on the surface of the light sensitive layer thus obtained, and this was followed by heating at 100°C for 5 minutes to crosslink the fluorine-containing polymer, whereby a hardened fluorine-containing polymer layer of 0.5 μm in thickness was formed.

Thereafter, the procedure of Example 3 was followed to prepare a waterless PS plate, which was then developed to yield a printing plate.

This printing plate was found to have a strongly adhered fluororesin layer in the exposed portion, and was subjected to the same printing process as in Example 3. A total of 20,000 sheets of printed matter having good dot reproducibility and good shadow reproducibility were obtained.

Example 7

The procedure of Example 3 was followed, but the following fluorine-containing polymer composition 7 was used in place of the fluorine-containing polymer composition 3 of Example 3 and the fluorine-containing polymer was crosslinked by heating at 90°C for 15 minutes after coating the fluorine-containing polymer composition 7 to form a adhered fluorine-containing polymer layer of 0.8 μm in thickness, whereby a waterless PS plate was prepared, which was then developed to yield a printing plate. This printing plate was found to have a strongly adhered fluororesin layer in the exposed portion, and subjected to the same printing process as in Example 3. A total of 20,000 sheets of printed matter having good dot reproducibility and good shadow reproducibility were obtained.

Fluorine-containing polymer composition 7

| | | |
|---|---|---|
| (1) | Copolymer resin of 1H,1H,2H,2H-heptadecafluorodecyl methacrylate [$CH_2=C(CH_3)COO(CH_2)_2(CF_2)_8F$], 2-hydroxyethyl methacrylate and methyl methacrylate in a molar ratio of 80:10:10 | 50 parts |
| (2) | Copolymer resin of 1H,1H,2H,2H-heptadecafluorodecyl methacrylate, maleic anhydride and methyl methacrylate in a molar ratio 70:20:10 | 50 parts |
| (3) | Tetraisopropyl titanate | 0.05 part |
| (4) | Flon-113 | 500 sheets |
| (5) | m-xylene hexafluoride | 100 parts |

Example 8

The procedure of Example 3 was followed, but the following resin was used in place of the resin (1) of the light sensitive composition 3 of Example 3 and the fluorine-containing polymer composition 7 of Example 7 was used in place of the fluorine-containing polymer composition 3 of Example 3, whereby a waterless PS plate was prepared and developed to yield a printing plate.

This printing plate was found to have a strongly adhered fluororesin layer in the exposed portion, and subjected to the same printing process as in Example 3. A total of 20,000 sheets of printed matter having good dot reproducibility and good shadow reproducibility were obtained.

Replacement resin

| | | |
|---|---|---|
| (1) | Resin obtained by adding glycidyl methacrylate to the carboxyl group of a copolymer resin of styrene, acrilonitrile, butyl acrylate, 2-hydroxyethyl methacrylate and acrylic acid in a molar ratio of 40:10:5:20:25 | 100 parts |

04637

## Claims

1. A waterless presensitized lithographic printing plate comprising a support having thereon a light-sensitive layer and a layer comprising a fluororesin in this order, wherein said fluororesin is a cross-linked fluorine-containing polymer.

2. The plate of claim 1, wherein said fluororesin is a fluorine-containing polymer cross-linked through a cross-linking agent.

3. The plate of claim 1, wherein said fluororesin is a cross-linked fluorine-containing polymer derived from a polymer having at least one group selected from the group consisting of $CF_3$-, $-CF_2$-, -CF-, $CF_3O$-, $-CF_2O$- and -CFO-and at least one group selected from the group consisting of -OH, -COOH, $-NH_2$, -NH-, -NCO,

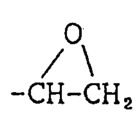

and $O=\overset{|}{C}-O-\overset{|}{C}=O$ in its molecular structure.

4. The plate of claim 1, wherein said fluororesin is a cross-linked fluorine containing polymer derived from a copolymer of a fluorine-containing acryl monomer and a monomer having a functional group selected from the group consisting of -OH, -COOH, $-NH_2$, -NH-, -NCO,

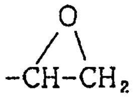

and O=C-O-C=O in its molecular structure.

5. The plate of claim 4, wherein said acryl monomer is a compound represented by Formula 1 ;
Formula 1

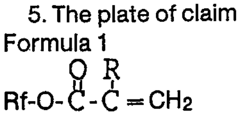

wherein Rf represents a fluorine-containing alkyl group or a fluorine-containing polyether group; R represents a hydrogen atom or an alkyl group.

6. The plate of claim 1, wherein said fluororesin is a cross-linked fluorine-containing polymer derived from a polymer having at least one group selected from the group consisting of -OH, -COOH, $-NH_2$ and -NH- in its molecular structure and a cross-linking agent having at least two groups selected from the group consisting of -NCO,

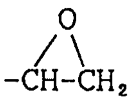

and O=C-O-C=O in its molecular structure.

7. The plate of claim 1, wherein said fluororesin is a cross-linked fluorine-containing polymer derived from a polymer having at least one group selected from the group consisting of -NCO,

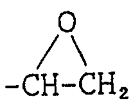

and O=C-O-C=O in its molecular structure and a cross-linking agent having at least two groups selected from the group consisting of -OH, -COOH, $-NH_2$ and -NH- in its molecular structure.

8. The plate of claim 1, wherein said fluororesin is a polymer bonding with a compound contained in said light-sensitive layer.

9. The plate of claim 8, wherein said fluororesin is a cross-linked fluorine-containing polymer derived from a polymer having at least one group selected from the group consisting of -OH, -COOH, $-NH_2$ and -NH- in its molecular structure and a cross-linking agent having at least two groups selected from the group consisting of -NCO,

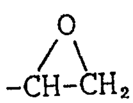

and O=C-O-C=O in its molecular structure and said compound contained in said light-sensitive layer has at least one group selected from the group consisting of -OH, -COOH, $-NH_2$ and -NH- in its molecular structure.

10. The plate of claim 8, wherein said fluororesin is a cross-linked fluorine-containing polymer derived from a polymer having at least one group selected from the group consisting of -NCO,

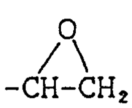

and O=C-O-C=O in its molecular structure and a cross-linking agent having at least two groups selected from the group consisting of -OH, -COOH, $-NH_2$ and -NH- in its molecular structure and said compound contained in said light-sensitive layer has at least one group selected from the group consisting of -NCO,

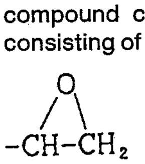

and O=C-O-C=O in its molecular structure.

11. The plate of claim 1, wherein the fluororesin content of said layer comprising a fluororesin is 60 to 100 % by weight.

12. The plate of claim 1, wherein the fluororesin content of said layer comprising a fluororesin is 80 to 98 % by weight.

13. The plate of claim 1, wherein the thickness of said layer comprising a f l uororesin is 0.01 to 10 μm.

14. The plate of claim 1, wherein the thickness of said layer comprising a fluororesin is 0.1 to 1 μm.

15. A method of manufacturing a waterless presensitized printing plate comprising a support having thereon a light-sensitive layer and a layer comprising a fluororesin in this order wherein said fluororesin is a cross-linked fluorine-containing polymer comprising a step consisting of;

(a) coating a light-sensitive layer on a support,

(b) coating a fluororesin containing layer thereon and

(c) heating the coated.